# EUROPEAN PATENT APPLICATION

(11) **EP 4 102 614 A1**
(43) Date of publication of application: **14.12.2022**
(21) Application number: 21757328.6
(22) Date of filing: 14.01.2021
(51) Int. Cl.: H01M 10/42, H02J 7/00, G01R 31/385, G01R 31/396

(54) **ELECTRIC QUANTITY MEASURING APPARATUS AND METHOD AND ELECTRONIC DEVICE**

(30) Priority: 21.02.2020 CN 202010108024
(71) Applicant: GUANGDONG OPPO MOBILE TELECOMMUNICATIONS CORP., LTD., Dongguan, Guangdong 523860 (CN)
(72) Inventor: ZHENG, Yicheng, Dongguan, Guangdong 523860 (CN); HAN, Bingquan, Dongguan, Guangdong 523860 (CN); QIU, Pei, Dongguan, Guangdong 523860 (CN)
(74) Representative: Ipside
(86) International application number: PCT/CN2021/071673
(87) International publication number: WO 2021/164475

(57) **Abstract**

An electric quantity measuring apparatus, comprising a battery unit (10); a sampling circuit (30) respectively connected to the battery unit and an interface module (20) and used for acquiring a current signal of the battery unit; and a charging management integrated circuit (40) provided with a voltage detection pin and a current detection pin, wherein the voltage detection pin is connected to the battery unit and the current detection pin is connected to the sampling circuit. The charging management integrated circuit is used for acquiring voltage information, current information and electric quantity information of the battery unit on the basis of a voltage signal detected by the voltage detection pin and a current signal detected by the current detection pin.

## Description

### CROSS REFERENCE TO RELATED APPLICATION

The present application claims priority of Chinese Patent Application No. 202010108024.4, in the title of "ELECTRIC QUANTITY MEASURING APPARATUS AND METHOD AND ELECTRONIC DEVICE", filed on February 21, 2020, the entire contents of which are hereby incorporated by reference in their entirety.

### TECHNICAL FIELD

The present disclosure relates to the field of charging technologies, and in particular to an electric quantity measuring apparatus and method and electronic device.

### BACKGROUND

The statements herein provide only background information relevant to the present disclosure and do not necessarily constitute prior art.

Electronic devices are playing an increasingly important role in people's lives, and the technology for charging electronic devices is evolving at an increasing rate. Conventionally, an electronic device is arranged with a power meter integrated circuit (IC) dedicated to detecting battery's electric quantity. The power meter IC may be further configured to detect battery voltage, current, calculate parameters such as battery capacity, temperature and current electric quantity, and may be connected to a charging management IC and a processing circuit of the electronic device via an inter-integrated circuit (I2C) for use.

However, when the power meter IC is applied in the electronic device to obtain the battery's electric quantity information, it is also necessary to arrange a corresponding hardware circuit for supporting, which increases the number of hardware elements in the electronic device, causing device redundancy and high cost.

### SUMMARY OF THE DISCLOSURE

The present disclosure provides an electric quantity measuring apparatus and method and electronic device.

An electric quantity measuring apparatus, including:
a battery unit;
a sampling circuit, connected to the battery unit and configured to obtain a current signal of the battery unit; and
a charging management integrated circuit, arranged with a voltage detection pin and a current detection pin; wherein the voltage detection pin is connected to the battery unit, and the current detection pin is connected to the sampling circuit;
the charging management integrated circuit is configured to detect a voltage signal of the battery unit based on the voltage detection pin, detect the current signal of the battery unit based on the current sampling pin, and obtain voltage information, current information, and electric quantity information of the battery unit.

An electric quantity measuring method, including:
receiving a configuration instruction;
configuring a voltage detection pin and a current detection pin according to the configuration instruction; wherein a positive voltage detection pin is connected to a first terminal of a sampling circuit and a cathode terminal of a battery unit; a negative voltage detection pin is connected to a second terminal of the sampling circuit; the sampling circuit is configured to obtain a current signal of the battery unit; and
obtaining voltage information, current information, and electric quantity information of the battery unit based on a voltage signal detected by the voltage detection pin and the current signal detected by the current sampling pin.

An electronic device, including:
a battery unit;
a sampling circuit, connected to the battery unit and configured to obtain a current signal of the battery unit;
a charging management integrated circuit, arranged with a voltage detection pin and a current detection pin; wherein the voltage detection pin is connected to the battery unit, and the current detection pin is connected to the sampling circuit;
the charging management integrated circuit is configured to detect a voltage signal of the battery unit based on the voltage detection pin, detect the current signal of the battery unit based on the current sampling pin, and obtain voltage information, current information, and electric quantity information of the battery unit; and
a processing circuit, connected to the battery unit and the charging management integrated circuit, and configured to receive the current signal, the voltage signal, and the electric quantity information output by the charging management integrated circuit and to manage the charging management integrated circuit.

By virtue of the above apparatus, method, and electronic device, the charging management integrated circuit is arranged with the voltage detection pin and the current detection pin. The charging management integrated circuit is configured to obtain voltage information, current information, and electric quantity information of the battery unit based on the voltage signal detected by the voltage detection pin and the current signal detected by the current sampling pin. In this way, the electric quantity information of the battery unit may be obtained without a power meter IC, which may simplify the hardware circuit of electric quantity measuring and reduce the cost.

Details of one or more embodiments of the present disclosure are presented in the accompanying drawings and description below. Other features, purposes and advantages of the present disclosure will become apparent from the specification, the accompanying drawings, and the claims.

### BRIEF DESCRIPTION OF THE DRAWINGS

In order to more clearly describe the technical solutions in the embodiments of the present disclosure or related art, the following will briefly introduce the drawings that need to be used in the description of the embodiments or the related art. Obviously, the drawings in the following description are only some embodiments of the present disclosure. For those skilled in the art, other drawings can be obtained based on these drawings without creative work.
FIG. 1 is a structural block view of an electric quantity measuring apparatus with a single battery according to an embodiment of the present disclosure.
FIG. 2 is a structural block view of an electric quantity measuring apparatus with dual batteries connected in series according to an embodiment of the present disclosure.
FIG. 3 is a structural block view of an electric quantity measuring apparatus with dual batteries connected in parallel according to an embodiment of the present disclosure.
FIG. 4 is a structural block view of an electric quantity measuring apparatus with a single battery according to another embodiment of the present disclosure.
FIG. 5 is a structural block view of an electric quantity measuring apparatus with dual batteries connected in series according to another embodiment of the present disclosure.
FIG. 6 is a structural block view of an electric quantity measuring apparatus with dual batteries connected in parallel according to another embodiment of the present disclosure.
FIG. 7 is a flowchart of an electric quantity measuring circuit according to an embodiment of the present disclosure.
FIG. 8 is a structural block view of an electronic device according to an embodiment of the present disclosure.

### DETAILED DESCRIPTION

In order to facilitate the understanding of the present disclosure and to make the above-mentioned objects, features and advantages of the present disclosure more obvious and understandable, the specific embodiments of the present disclosure will be described in detail below with reference to the accompanying drawings. In the following description, many specific details are set forth in order to fully understand the present disclosure, and the preferred embodiments of the present disclosure are shown in the accompanying drawings. However, the present disclosure may be implemented in many different forms and is not limited to the embodiments described herein. On the contrary, the purpose of providing these embodiments is to make the present disclosure more thorough and comprehensive. The present disclosure may be implemented in many other ways different from those described herein, and those skilled in the art can make similar improvements without departing from the connotation of the present disclosure. Therefore, the present disclosure is not limited by the specific embodiments disclosed below.

In addition, the terms "first" and "second" are only used for descriptive purposes, and cannot be understood as indicating or implying relative importance or implicitly indicating the number of indicated technical features. Therefore, the features defined with "first" and "second" may explicitly or implicitly include at least one of the features. In the description of the present disclosure, "a plurality of' means at least two, such as two, three, etc., unless otherwise specifically defined. In the description of the present disclosure, "several" means at least one, such as one, two, etc., unless otherwise specifically defined.

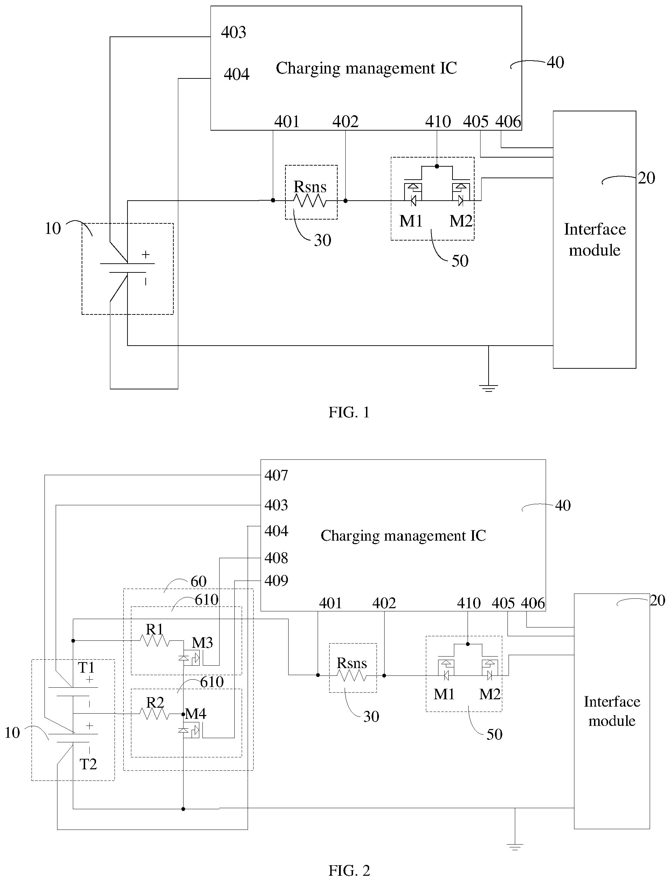

As shown in FIG. 1, in the embodiments, the electric quantity measuring apparatus includes a battery unit 10, a sampling circuit 30, and a charging management integrated circuit 40.

The battery unit 10 includes at least one battery. The type of each battery may be at least one of a lead-acid battery, a nickel-hydrogen battery, a sodium-sulfur battery, a flow battery, a super capacitor, a lithium battery, and a flexible battery. The at least one battery in the battery unit 10 is same in type, and the number of the at least one battery included in the battery unit 10 may be 1, 2, 3, or more.

In the present disclosure, a lithium battery is taken as an example for description. Among them, the lithium battery includes a battery core. The battery core may include a cathode sheet and an anode sheet that are wound, and a diaphragm disposed between the cathode sheet and the anode sheet. A metal conductor that can be drawn from the cathode sheet of the battery core is called a cathode tab, and a metal conductor that can be drawn from the anode sheet of the battery core is called an anode tab.

In some embodiments, the cathode tab is adopted with a copper sheet plated with a nickel layer on the surface, and the anode tab is adopted with an aluminum sheet. The nickel layer may be used as a protective layer of the copper sheet to prevent increasing of the internal resistance and deteriorating of the electrical conductivity caused by the oxidation of the copper sheet. The electrical conductivity of the aluminum sheet is high, and the temperature rise of the tab is low when a large current passes. In addition, the hardness of the aluminum sheet is small, and it is not easy to pierce the diaphragm or adjacent cells. In this way, the safety performance of the battery unit 10 is improved.

When the battery unit 10 includes one battery, the cathode tab of the single battery may be understood as a cathode terminal of the battery unit 10, and the anode tab of the single battery may be understood as an anode terminal of the battery unit 10.

When the battery unit 10 includes multiple batteries, the multiple batteries in the battery unit 10 may be connected in series or in parallel. Exemplarily, when the battery unit 10 includes n batteries connected in series, the n batteries connected in series may be respectively denoted as first battery, second battery, ..., nth battery. The cathode tab of the first battery may be understood as the cathode terminal of the battery unit 10, and the anode tab of the nth battery may be understood as the anode terminal of the battery unit 10. When the battery unit 10 includes n batteries connected in parallel, a common connection terminal of the cathode tabs of the n batteries may be understood as the cathode terminal of the battery unit 10, and the common connection terminal of the anode tabs of the n batteries may be understood as the anode terminal of the battery unit 10.

It should be noted that in the embodiments of the present disclosure, the number of batteries in the battery unit 10 is not further limited.

The sampling circuit 30 is connected to the battery unit 10 and is configured to collect a current signal of the battery unit 10. In some embodiments, the sampling circuit 30 may be a sampling resistor Rsns.

The charging management integrated circuit 40 can also be understood as a charge control integrated circuit (IC). The charging management integrated circuit 40 may be arranged with a voltage detection pin and a current detection pin. The voltage detection pin is connected to the battery unit 10, and the current detection pin is connected to the sampling circuit 30. The charging management integrated circuit 40 may detect a voltage signal of the battery unit 10 based on the voltage detection pin, detect a current signal of the battery unit 10 based on the current sampling pin, and obtain electric quantity information of the battery unit 10 according to the voltage signal and the current signal.

When the voltage detection pin and the current detection pin are arranged in the charging management integrated circuit 40, a program for starting the voltage detection pin and the current detection pin may be written into the charging management integrated circuit 40, such that the voltage detection pin of the charging management integrated circuit 40 has a voltage detection function, and the current detection pin of the charging management integrated circuit 40 has a current detection function.

In some embodiments, the number of the current detection pins is two, which may specifically include a positive current detection pin 401 and a negative current detection pin 402. The positive current detection pin 401 is connected to a first terminal of the sampling circuit 30 and the cathode terminal of the battery unit 10, and the negative current detection pin 402 is connected to a second terminal of the sampling circuit 30 and an interface module 20.

The number of the voltage detection pins is correlated with the number of batteries in the battery unit 10, which includes at least a positive voltage detection pin 403 and a negative voltage detection pin 404. Exemplarily, when the battery unit 10 includes only one battery, the positive voltage detection pin 403 may be connected to the cathode tab of the battery, and the negative voltage detection pin 404 may be connected to the anode tab of the battery. By connecting the voltage detection pin directly to the tab of the battery, an error caused by a path impedance may be reduced to improve the sampling accuracy of the voltage signal.

When the battery unit 10 includes multiple batteries and the connection modes between the multiple batteries are different, the number of voltage detection pins is also different, and the connection modes between the voltage detection pins and the multiple batteries are also different, which will be described in detail in the subsequent embodiments.

In some embodiments, the charging management integrated circuit 40 is further integrated with a high-precision analog-to-digital converter to collect the voltage signal through the voltage detection pin and collect the current signal through the current detection pin, for performing analog-to-digital conversion to obtain voltage information and current information of the battery unit 10. The charging management integrated circuit 40 may further calculate the current electric quantity information of the battery unit 10 according to the obtained voltage information and current information.

In some embodiments, the electric quantity measuring apparatus further includes an interface module 20. The interface module 20 is respectively connected to the battery unit 10 and the sampling circuit 30 and configured to be connected to a charging device. The interface module 20 may include a charging interface such as VBUS, USB+, USB-, and GND. When the interface module 20 is connected to the charging device, the charging device can charge the battery unit 10. The charging device connected to the charging interface may be a fast-charging adapter, a common adapter, a power bank, or a terminal capable of charging the battery unit 10 of the electronic device, etc. For example, the fast-charging adapter can provide charging power greater than 15W. The common adapter may be a 5V/1A, 5V/2A charging device.

It should be noted that the present disclosure does not limit the interface type in the interface module 20, for example, it may be a Micro-USB interface, a Type-C interface, a 30-pin interface, a lightning interface, etc.

In some embodiments, the sampling resistor Rsns is arranged in a charging circuit formed by the interface module 20 and the battery unit 10. Exemplarily, a first terminal of the sampling resistor Rsns may be connected to the cathode terminal of the battery unit 10, and a second terminal of the sampling resistor Rsns may be connected to a VBUS interface in the interface module 20.

Specifically, in a case where the interface module 20 is connected to an external charging device to charge the battery unit 10 or the battery unit 10 is in a discharging state, when a current charging current or a current discharging current of the battery unit 10 collected by the charging management integrated circuit 40 is less than a preset value, a current voltage value of the battery unit 10 is obtained, and an initial electric quantity is obtained according to a preset mapping relationship table between a voltage value and the initial electric quantity. When the charging current is greater than or equal to the preset value, the current value may be integrated to obtain an integration, and the current electric quantity information may be obtained by accumulating with adding the initial electric quantity and the integration. When the charging current is greater than or equal to the preset value, the current value may be integrated to obtain an integration, and the current electric quantity information is obtained by accumulating with subtracting the initial electric quantity and the integration.

It should be noted that the preset value may be 1mA, 2mA, 5mA, 10mA, etc., which may be set according to an internal resistance of the battery unit 10, electrochemical reaction parameters, etc. The present disclosure does not make any limitation on the specific value thereof.

In the above-mentioned electric quantity measuring apparatus, the charging management integrated circuit 40 is arranged with a voltage detection pin and a current detection pin. The charging management integrated circuit 40 is configured to obtain voltage information, current information, and electric quantity information of the battery unit 10 based on a voltage signal detected by the voltage detection pin and a current signal detected by the current sampling pin. In this way, the electric quantity information of the battery unit 10 may be obtained without a power meter IC, which may simplify the hardware circuit of electric quantity measuring and reduce the cost.

The charging management integrated circuit 40 may be further arranged with a control pin and communication pins 405 and 406, the communication pins 405 and 406 being connected to the interface module 20. When the interface module 20 is connected to the charging device, communication may be realized with the connected charging device through the communication pins 405 and 406, and the type of the charging device may be obtained.

In some embodiments, the electric quantity measuring apparatus further includes a charging circuit 50 connected to the interface module 20, the sampling circuit 30, and the control pin.

The charging circuit 50 may include two electronic switch tubes connected in series. Each electronic switching tube may be a switching tube with three connection terminals, such as a triode, a MOS tube, an IGBT, etc. Exemplarily, the charging circuit 50 may include a first MOS tube M1 and a second MOS tube M2. The gate of the first MOS tube M1 and the gate of the second MOS tube M2 are both connected to the control pin; the drain of the first MOS tube M1 is connected to the interface module 20, the source of the first MOS tube M1 is connected to the source of the second MOS tube M2, and the drain of the second MOS tube M2 is connected to the sampling circuit 30. When the type of the charging device is a preset type, the charging device may control the control pin 410 to output a charging instruction to the charging circuit 50 to turn on a charging path between the interface module 20 and the battery unit 10 to charge the battery unit 10. Exemplarily, when the charging device connected to the interface module 20 is a fast-charging adapter, the charging management integrated circuit may output a high-level control signal to the gate of the first MOS tube M1 and the gate of the second MOS tube M2, such that the first MOS transistor M1 and the second MOS transistor M2 are both in an on state, and the battery unit 10 can be charged in a fast-charging mode through the fast-charging adapter.

Further, the charging management integrated circuit 40 may feedback and adjust the charging current or the charging voltage output by the charging circuit 50 based on the current information, voltage information, electric quantity information, and temperature information obtained by the charging management integrated circuit 40 to output a point signal suitable for charging the battery unit 10.

In some embodiments, the charging circuit 50 may further include multiple electronic switch tubes all connected in series between the battery unit 10 and the interface module 20. In the embodiments of the present disclosure, the number and types of the electronic switch tubes in the charging circuit 50 are not further limited, as long as the electronic switch tubes can be in the on state under the control of the charging management integrated circuit to charge the battery unit 10 by the charging device.

In some embodiments, the battery unit 10 may further include n batteries connected in series. Among them, the n batteries connected in series may be respectively denoted as first battery, second battery, ..., nth battery, where n≥2. Exemplarily, as shown in FIG. 2, taking n=2 as an example for description, the battery unit 10 includes two batteries connected in series, which may be denoted as a first battery T1 and a second battery T2. The voltage detection pin includes a positive voltage detection pin 403, a terminal voltage detection pin 407, and a negative voltage detection pin 404. The positive voltage detection pin 403 is connected to the cathode tab of the first battery T1, the terminal voltage detection pin 407 is connected to the cathode tab of the second battery T2, and the negative voltage detection pin 404 is connected to the anode tab of the second battery T2.

In some embodiments, when n>2, the voltage detection pin includes a positive voltage detection pin 403, a negative voltage detection pin 404, and n-1 terminal voltage detection pins. Specifically, the cathode tab of the first battery is connected to the positive voltage detection pin 403, the anode tab of the nth battery is connected to the negative voltage detection pin 404, and a common terminal of each adjacent batteries is connected to a corresponding terminal voltage detection pin in a one-by-one manner. Exemplarily, the n-1 terminal voltage detection pins may be respectively denoted as terminal voltage detection pins 407₁, 407₂, ..., 407ₙ₋₁. It can also be understood that the cathode tab of each of the second battery to the nth battery is connected to a corresponding terminal voltage detection pin in a one-by-one manner. That is, the cathode tab of the second battery is connected to the terminal voltage detection pin 407₁, the cathode tab of the third battery is connected to the terminal voltage detection pin 407₂, and so on, the cathode tab of the nth battery is connected to the terminal voltage detection pin 407ₙ₋₁.

The charging management integrated circuit 40 may correspondingly obtain the voltage signal detected by each voltage detection pin and correspondingly obtain the voltage signal of each battery, and obtain the voltage signal of the battery unit 10 according to the voltage signal of each battery. Exemplarily, the voltage information of the first battery T1 may be obtained by calculating according to signals of the positive voltage detection pin 403 and the terminal voltage detection pin 407, and the voltage information of the second battery T2 may be obtained by calculating according to signals of the terminal voltage detection pin 407 and the negative voltage detection pin 404. The voltage signal of the battery unit 10 may be the sum of the voltage information of each battery.

In some embodiments, the battery unit 10 includes multiple batteries connected in series. The battery unit 10 may have a battery capacity mismatch in either the charging state or the discharging state. The battery capacity mismatch may include a state of charge (SOC) mismatch and a capacity/energy (C/E) mismatch. When the battery capacity does not match, the battery unit 10 needs to be equalized. The electric quantity measuring apparatus further includes a first equalization circuit 60, the charging management integrated circuit 40 is further arranged with first equalization pins, and the first equalization circuit 60 is respectively connected to the battery unit 10 and the first equalization pins. The charging management integrated circuit 40 is further configured to control each first equalization pin to output a first equalization signal. The first equalization circuit 60 is configured to equalize the batteries according to the first equalization signal.

Further, the number of first equalization pins is equal to the number of batteries, and both are n. The first equalization circuit 60 includes n cascaded first equalization units 610. A first terminal of the first equalization unit 610 of each stage is connected to the cathode of a battery in a one-to-one correspondence, and a third terminal of the first equalization unit 610 of each stage is connected to an equalization pin in a one-to-one correspondence. A second terminal of the first equalization unit 610 of a n-1th stage is connected to a first terminal of the first equalization unit 610 of a nth stage, and a second terminal of the first equalization unit 610 of the nth stage is grounded.

Referring to FIG. 2, specifically, the first equalization unit 610 includes a first equalization resistor and a first equalization tube; a first terminal of the first equalization resistor is connected to the cathode of the battery as a first terminal of the first equalization unit 610, a second terminal of the first equalization resistor is connected to a first terminal of the first equalization tube, a second terminal of the first equalization tube serves as a second terminal of the first equalization unit 610, and a third terminal of the first equalization tube serves as a third terminal of the first equalization unit 610.

In some embodiments, the first equalization tube 510 may be a MOS tube. A drain of the MOS tube serves as the first terminal of the first equalization tube, a source of the MOS tube serves as the second terminal of the first equalization tube, and a gate of the MOS tube serves as the third terminal of the first equalization tube.

Exemplarily, when the battery unit 10 includes a first battery T1 and a second battery T2, a MOS tube M3 and a resistor R1 are configured to equalize the first battery T1, and a MOS tube M4 and a resistor R2 are configured to equalize the second battery T2. A drain of the MOS tube M3 is connected to a cathode tab of the first battery T1 via the resistor R1; a drain of the MOS tube M4 is connected to a cathode tab of the second battery T2 via the resistor R2; a source of the MOS tube M3 is connected to the drain of the MOS tube M4, and the drain of the MOS transistor M3 is connected to the first equalization pin 408, and a gate of the MOS transistor M4 is connected to the first equalization pin 409.

When the voltage signals of the multiple batteries meet an equalization condition, the first equalization pins 408 and 409 are controlled to correspondingly output equalization signals such that the first equalization units 610 of the first equalization circuit 60 equalize the multiple batteries.

In a case where the external charging device charges multiple batteries connected in series, when a voltage difference between the multiple batteries is greater than a preset voltage value, the equalization condition is met. Exemplarily, in a case where the external charging device charges a first battery T1 and a second battery T2 connected in series, the charging management integrated circuit 40 may obtain current and voltage values of the first battery T1 and the second battery T2 through the voltage detection pin and the current detection pin correspondingly. For example, when the voltage of the first battery T1 is greater than the voltage of the second battery T2, the charging management integrated circuit 40 may control to turn on the MOS tube M3 connected in parallel with the first battery T1 and turn off the MOS tube M4 connected in parallel with the second battery T2. At this time, charging may be continued, and the current flowing through the first battery T1 can be less than the current flowing through the second battery T2, such that the voltage of the second battery T2 is increased, and the voltages of the first battery T1 and the second battery T2 remain equalized. Conversely, when the voltage of the first battery T1 is less than the voltage of the second battery T2, the charging management integrated circuit 40 may control to turn off the MOS tube M3 connected in parallel with the first battery T1 and turn on the MOS tube M4 connected in parallel with the second battery T2. At this time, charging may be continued, and the current flowing through the first battery T1 can be greater than the current flowing through the second battery T2, such that the voltage of the first battery T1 is increased, and a voltage difference of the first battery T1 and the second battery T2 is kept within a certain range.

It should be noted that when the battery unit 10 includes n batteries connected in series, n first equalization units 610 may be arranged correspondingly, and the voltage signal of each battery is detected and obtained. When the voltage of one or more batteries meets the equalization condition, the on-off state of the MOS tube connected in parallel with the battery may be controlled accordingly, such that the voltage difference of each battery is not kept within a certain range to achieve equalization.

In the embodiments of the present disclosure, by arranging the charging management integrated circuit 40 with corresponding equalization pins and correspondingly arranging the first equalization circuit 60, the equalization processing of multiple batteries connected in series may be realized, which may replace the equalization IC in the traditional equalization circuit, simplifying the equalization circuit and reducing the cost.

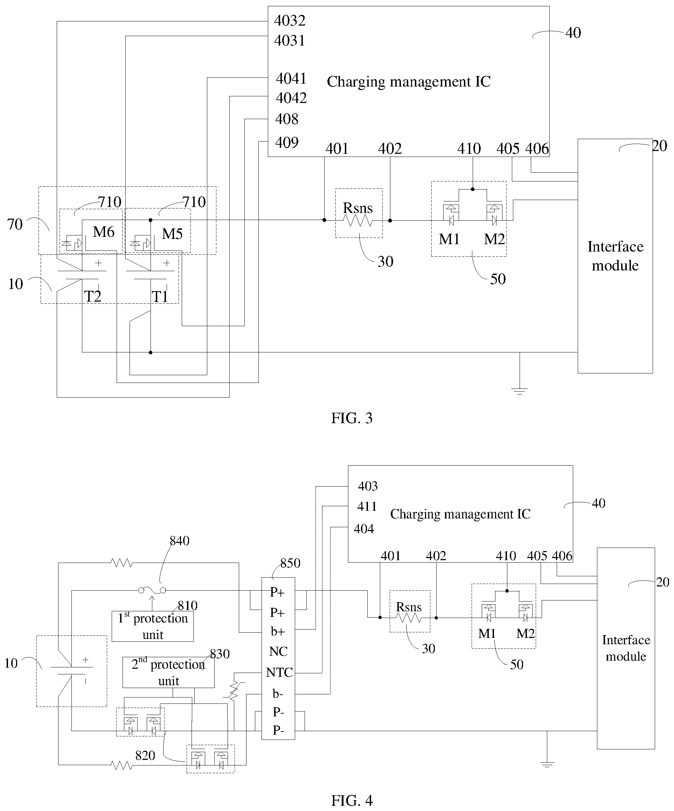

In some embodiments, the battery unit 10 may further include n batteries connected in parallel in sequence. The n batteries connected in parallel may be respectively denoted as first battery T1, second battery T2, ..., nth battery, where n≥2. Exemplarily, as shown in FIG. 3, taking n=2 as an example for description, the battery unit 10 includes two batteries connected in parallel, which may be denoted as a first battery T1 and a second battery T2. A positive current detection pin 401 is connected to a cathode terminal of the battery unit 10, and a negative current detection pin 402 is connected to an anode terminal of the battery unit 10, for detecting the current signal of the battery unit 10. Among them, the voltage detection pins include two pairs of positive voltage detection pins 403 and negative voltage detection pins 404 (4031, 4041), (4032, 4042). A cathode tab of the first battery T1 is connected to the positive voltage detection pin 4031, an anode tab of the first battery T1 is connected to the negative voltage detection pin 4041; a cathode tab of the second battery T2 is connected to the positive voltage detection pin 4032, and an anode tab of the second battery T2 is connected to the negative voltage detection pin 4042.

In some embodiments, when n>2, the cathode and anode tabs of each battery are connected to a pair of positive voltage detection pins 403 and negative voltage detection pins 404 correspondingly. Exemplarily, n pairs of positive voltage detection pins 403 and negative voltage detection pins 404 may be represented by (4031,4041), (4032,4042), ..., (403n,404n), respectively. Among them, "403" refers to positive voltage detection pin 403, and "404" refers to negative voltage detection pin 404. The cathode tab of the first battery T1 is connected to the positive voltage detection pin 4031, and the anode tab of the first battery T1 is connected to the negative voltage detection pin 4041. Correspondingly, the cathode tab of the nth battery is connected to the positive voltage detection pin 403n, and the anode tab of the first battery T1 is connected to the negative voltage detection pin 404n.

The charging management integrated circuit 40 may obtain the detected voltage signal of each voltage detection pin and correspondingly obtain the voltage signal of each battery, and further obtain the voltage signal of the battery unit 10 according to the voltage signal of each battery. Exemplarily, the voltage information of the first battery T1 may be obtained by calculating according to the difference between the positive voltage detection pin 4031 and the negative voltage detection pin 4041, and the voltage information of the second battery T2 may be obtained by calculating according to the positive voltage detection pin 4032 and the negative voltage detection pin 4042. The charging management integrated circuit 40 may further obtain the voltage information of the battery unit 10 according to the voltage information of the first battery T1 and the second battery T2.

In some embodiments, the battery unit 10 includes multiple batteries connected in parallel. The battery unit 10 may have a battery capacity mismatch in either the charging state or the discharging state. The battery capacity mismatch may include a state of charge (SOC) mismatch and a capacity/energy (C/E) mismatch. When the battery capacity does not match, the battery unit 10 needs to be equalized. The current measuring apparatus further includes a second equalization circuit 70, the charging management integrated circuit 40 is further arranged with second equalization pin, and the second equalization circuit 70 is respectively connected to the battery unit 10 and the second equalization pins. The charging management integrated circuit 40 is further configured to control each second equalization pin to output a second equalization signal. The second equalization circuit 70 is configured to equalize the batteries according to the second equalization signal.

Further, the second equalization circuit 70 includes n second equalization units 710. A first terminal of each second equalization unit 710 is connected in series with the cathode of a battery in a one-to-one correspondence, a second terminal of each second equalization unit 710 is connected to the sampling circuit 30, and a third terminal of each second equalization unit 710 is connected to a second equalization pin in a one-to-one correspondence.

Referring to FIG. 3, specifically, the second equalization unit 710 includes a second equalization tube. In some embodiments, the second equalization tube may be a MOS tube. Exemplarily, when the battery unit 10 includes a first battery T1 and a second battery T2, a MOS tube M5 is configured to equalize the first battery T1, and a MOS tube M6 is configured to equalize the second battery T2. A source of the MOS tube M5 is connected to the cathode tab of the first battery T1, a drain of the MOS tube M5 is connected to the sampling circuit 30, and a gate of the MOS tube M5 is connected to the second equalization pin 408; a source of the MOS tube M6 is connected to the cathode tab of the second battery T2, a drain of the MOS tube M6 is connected to the sampling circuit 30, and a gate of the MOS tube M6 is connected to the second equalization pin 409.

When the voltage signals of the multiple batteries meet an equalization condition, the second equalization pins are controlled to output equalization signals such that the second equalization circuit 70 equalizes the multiple batteries.

In a case where the external charging device charges multiple batteries connected in parallel, the charging current will be high on a side of a small impedance, when a charging impedance difference between the batteries while charging is large. When the current of a battery is too large, its voltage will also be biased, and the battery is thus required to be equalized. That is, when the voltage difference between the multiple batteries is greater than the preset voltage value, the equalization condition is met. Exemplarily, in a case where the external charging device charges the first battery T1 and the second battery T2 connected in parallel, when the voltage difference between the first battery T1 and the second battery T2 meets the equalization condition, the second equalization pin 408 or 409 may be used to adjust a Vgs voltage of the correspondingly connected MOS tube (M5 or M6), thereby changing the impedance of the MOS tube (M5 or M6) in the corresponding path to compensate for the impedance difference between the first battery T1 and the second battery T2. The greater the Vgs voltage of a MOS tube, the less the impedance of the MOS tube; the less the Vgs voltage of the MOS tube, the greater the impedance of the MOS tube. By compensating for the impedance difference between the first battery T1 and the second battery T2, a current distribution relationship between the first battery T1 and the second battery T2 may be correspondingly controlled to ensure that the voltage difference between the first battery T1 and the second battery T2 is maintained within a certain range to achieve equalization.

It should be noted that when the battery unit 10 includes n batteries connected in parallel, n second equalization units 710 may be arranged correspondingly, and the voltage signal of each battery is detected and obtained. When the voltage of one or more batteries meets the equalization condition, the Vgs voltage of the MOS tube connected in series with the battery may be controlled correspondingly, such that the voltage difference of each battery is not kept within a certain range to achieve equalization.

In the embodiments of the present disclosure, by arranging the charging management integrated circuit 40 with corresponding equalization pins and correspondingly arranging the second equalization circuit 70, the equalization processing of multiple batteries connected in parallel may be realized, which may replace the equalization IC in the traditional equalization circuit, simplifying the equalization circuit and reducing the cost.

In some embodiments, the apparatus further includes a temperature detection circuit for detecting temperature information of the battery unit 10. Specifically, the temperature detection circuit may be a thermistor. Exemplarily, the temperature detection circuit may be a negative temperature coefficient (NTC) thermistor. The charging management integrated circuit 40 is further arranged with a temperature detection, a first terminal of the temperature detection circuit is connected to the anode terminal of the battery unit 10, and a second terminal of the temperature detection circuit is connected to the temperature detection pins. The charging management integrated circuit 40 is further configured to obtain the temperature information of the battery unit 10.

In some embodiments, the apparatus further includes a protection circuit 80 connected to the battery unit 10 and the charging management integrated circuit 40, respectively. The protection circuit 80 is configured to protect the battery unit 10 from over-voltage or over-current, as well as over-discharge or over-charge under the control of the protection circuit of the charging management integrated circuit 40.

In some embodiments, the electric quantity measuring apparatus further includes a protection board, and the battery unit 10 and the protection circuit are both arranged on the protection board. Further, the protection board further includes a connector 850 configured to connecting the battery unit 10 and the protection circuit to the charging management integrated circuit 40 and the interface module 20. Exemplarily, the connector 850 may be a board-to-board (BTB) connector 850. The connector 850 is arranged with multiple interfaces, such as P+ interface, P- interface, b+ interface, b- interface, NTC interface, Hdis interface, Ldis interface, be interface, etc. Among them, the P+ interface is configured to connect to the positive current detection pin 401, the P- interface is configured to connect to the negative current detection pin 402, the b+ interface is configured to connect to the positive voltage detection pin 403, the b- interface is configured to connect to the negative voltage detection pin 404, the Hdis interface is configured to connect to an equalization pin, and the Ldis interface is configured to connect to another equalization pin, etc.

It should be noted that the number and types of interfaces on the connector 850 need to match the number of batteries, the connection method, and the pins configured for the charging management integrated circuit 40.

Further, the protection circuit may include a first protection unit 810, multiple MOS transistors 820 arranged back-to-back, a second protection unit 830, a three-terminal fuse 840, and multiple current limiting resistors.

In some embodiments, as shown in FIG. 4, when the battery is a single cell, the protection circuit may include a first protection unit 810, two back-to-back MOS transistors 820, a second protection unit 830, a three-terminal fuse 840, and two current limiting circuits.

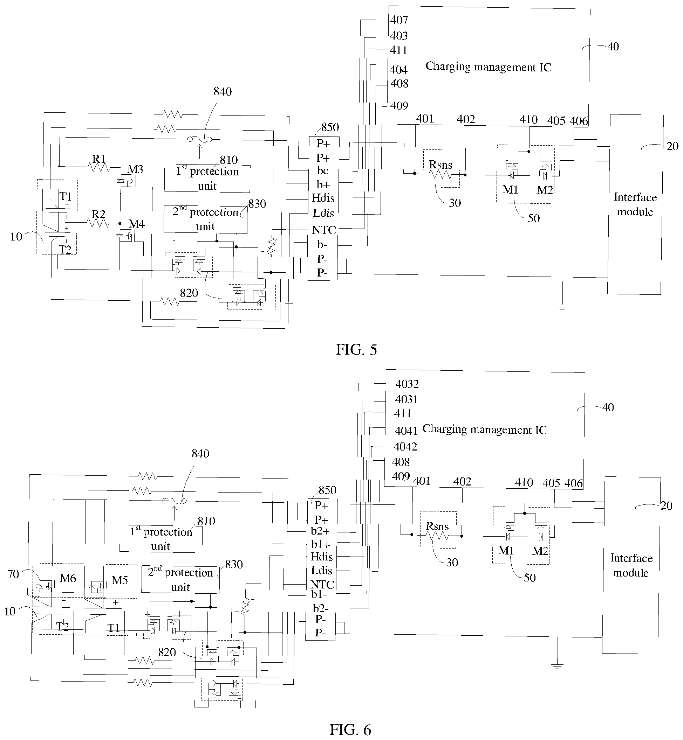

In some embodiments, as shown in FIG. 5, when the battery includes dual cells connected in series, the protection circuit may include a first protection unit 810, two back-to-back MOS transistors 820, a second protection unit 830, a three-terminal fuse 840, and three current limiting resistors.

In some embodiments, as shown in FIG. 6, when the battery includes dual cells connected in parallel, the protection circuit may include a first protection unit 810, three back-to-back MOS transistors 820, a second protection unit 830, a three-terminal fuse 840, and four current limiting resistors.

The first protection unit 810 and the second protection unit may be configured to detect the voltage and current of the battery unit 10. When the current or voltage is too large, the first protection unit 810 may drive the back-to-back MOS transistors to disconnect to prevent the battery from overcharging or over-discharging. When the current or voltage is too large, the second protection unit 830 may drive to blow the three-terminal fuse 840 to prevent safety problems caused by battery overvoltage or overcurrent. The current limiting resistor may be arranged between the cathode tab of the battery and the b+ (or b1+, b2+) interface of the connector 850, and another current limiting resistor may be arranged between the anode tab of the battery and the b- (or b1-, b2-) interface of the connector 850, thereby preventing the battery from being damaged by the large current burning out of the voltage detection circuit when the b+ interface and the P- interface are short-circuited by mistake.

The division of the modules in the above-mentioned electric quantity measuring apparatus is only for illustration. In other embodiments, the electric quantity measuring apparatus may be divided into different modules as needed to complete all or part of the functions of the above-mentioned electric quantity measuring apparatus.

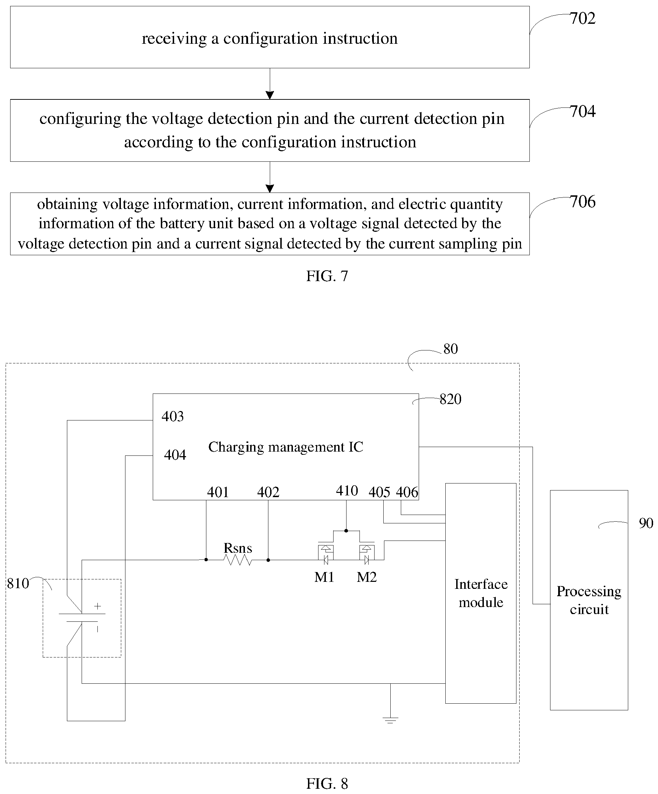

The present disclosure further provides an electric quantity measuring method, which is applied to the electric quantity measuring apparatus in any of the above embodiments. In some embodiments, the electric quantity measuring method includes operations 702-706 at blocks illustrated in FIG. 7.

At block 702: receiving a configuration instruction.

At block 704: configuring the voltage detection pin and the current detection pin according to the configuration instruction.

At block 706: obtaining voltage information, current information, and electric quantity information of the battery unit 10 based on a voltage signal detected by the voltage detection pin and a current signal detected by the current sampling pin.

The charging management integrated circuit 40 may receive the configuration instruction, which may be understood as a program for starting the voltage detection pin and the current detection pin, such that the voltage detection pin of the charging management integrated circuit 40 has a voltage detection function, and the current detection pin of the charging management integrated circuit 40 has a current detection function.

In some embodiments, the number of current detection pins is two, which may specifically include a positive current detection pin 401 and a negative current detection pin 402. The positive current detection pin 401 is connected to a first terminal of the sampling circuit 30 and the cathode terminal of the battery unit 10, and the negative current detection pin 402 is connected to a second terminal of the sampling circuit 30 and the interface module 20.

The number of the voltage detection pins is correlated with the number of batteries in the battery unit 10, which includes at least a positive voltage detection pin 403 and a negative voltage detection pin 404. Exemplarily, when the battery unit 10 includes only one battery, the positive voltage detection pin 403 may be connected to the cathode tab of the battery, and the negative voltage detection pin 404 may be connected to the anode tab of the battery. By connecting the voltage detection pin directly to the tab of the battery, an error caused by a path impedance may be reduced to improve the sampling accuracy of the voltage signal.

When the battery unit 10 includes multiple batteries and the connection modes between the multiple batteries are different, the number of voltage detection pins is also different, and the connection modes between the voltage detection pins and the multiple batteries are also different, which will be described in detail in the subsequent embodiments.

In some embodiments, the charging management integrated circuit 40 is further integrated with a high-precision analog-to-digital converter to collect the voltage signal through the voltage detection pin and collect the current signal through the current detection pin, for performing analog-to-digital conversion to obtain voltage information and current information of the battery unit 10. The charging management integrated circuit 40 may further calculate the current electric quantity information of the battery unit 10 according to the obtained voltage information and current information.

Specifically, in a case where the interface module 20 is connected to an external charging device to charge the battery unit 10 or the battery unit 10 is in a discharging state, when a current charging current or a current discharging current of the battery unit 10 collected by the charging management integrated circuit 40 is less than a preset value, a current voltage value of the battery unit 10 is obtained, and an initial electric quantity is obtained according to a preset mapping relationship table between a voltage value and the initial electric quantity. When the charging current is greater than or equal to the preset value, the current value may be integrated to obtain an integration, and the current electric quantity information may be obtained by accumulating with adding the initial electric quantity and the integration. When the charging current is greater than or equal to the preset value, the current value may be integrated to obtain an integration, and the current electric quantity information is obtained by accumulating with subtracting the initial electric quantity and the integration.

It should be noted that the preset value may be 1mA, 2mA, 5mA, 10mA, etc., which may be set according to an internal resistance of the battery unit 10, electrochemical reaction parameters, etc. The present disclosure does not make any limitation on the specific value thereof.

In the embodiments, the charging management integrated circuit 40 is arranged with a voltage detection pin and a current detection pin. The charging management integrated circuit 40 is configured to obtain voltage information, current information, and electric quantity information of the battery unit 10 based on a voltage signal detected by the voltage detection pin and a current signal detected by the current sampling pin. In this way, the electric quantity information of the battery unit 10 may be obtained without a power meter IC, which may simplify the hardware circuit of electric quantity measuring and reduce the cost.

In some embodiments, when the battery unit 10 includes multiple batteries, the electric quantity measuring method further includes obtaining a voltage signal of each battery in the battery unit 10; in response to the voltage signal of each battery meeting an equalization condition, controlling an equalization circuit to perform an equalization process on the battery unit 10. The equalization circuit is connected to each battery respectively.

In the embodiments of the present disclosure, by arranging the charging management integrated circuit 40 with corresponding equalization pins and correspondingly arranging the equalization circuit, the equalization processing of multiple batteries may be realized, which may replace the equalization IC in the traditional equalization circuit, simplifying the equalization circuit and reducing the cost.

It should be understood that although the various steps in the flowchart of FIG. 7 are displayed in sequence as indicated by the arrows, these steps are not necessarily performed in sequence in the order indicated by the arrows. Unless there is a clear description in this article, there is no strict order for the execution of these steps, and these steps may be executed in other orders. Moreover, at least part of the steps in FIG. 7 may include multiple sub-steps or multiple stages. The sub-steps or stages are not necessarily executed at the same time, but may be executed at different times. The execution of the sub-steps or stages is not necessarily performed sequentially, but may be performed in turn or alternately with other steps or at least some of the sub-steps or stages of other steps.

The present disclosure further provides a computer-readable storage medium. Disclosed may be one or more non-volatile computer-readable storage medium containing a computer-executable instruction. When the computer-executable instruction is executed by one or more processors, the one or more processors are caused to execute the steps of the charging control method.

Disclosed is further a computer program product containing an instruction. When the computer program product runs on a computer, the computer is caused to execute the charging control method.

The present disclosure further provides an electronic device. As shown in FIG. 8, in some embodiments, the electronic device includes the electric quantity measuring apparatus 80 and the processing circuit 90 in any of the above embodiments. The processing circuit is respectively connected to the battery unit 810 and the charging management integrated circuit 820, and is configured to receive current signal, voltage signal, and electric quantity information output by the charging management integrated circuit 820, and to manage the charging management integrated circuit 820. Exemplarily, the processing circuit may be a system-on-chip (SOC), which integrates CPU, GPU, RAM, communication baseband, GPS module, etc.

The charging management integrated circuit 820 may be further configured to receive an adjustment instruction output by the processing circuit to adjust the charging current or charging voltage output by the charging circuit.

In conventional electronic devices, the power meter IC, equalization IC, processing circuit and charging management integrated circuit 820 need to be set. In conventional electronic devices, the processing circuit needs to communicate with the power meter IC to obtain parameters such as voltage, current, and power from the power meter IC, and the processing circuit also needs to communicate with the charging management integrated circuit 820 to obtain the current charging state of the battery power, and when there is an abnormality, the charging management integrated circuit 820 may be controlled to shut down the charging. In the electronic device provided by the embodiments of the present application, the power meter IC and equalization IC in the electronic device may be omitted, and the electric quantity measuring apparatus may transmit the voltage information, current information, power information, and temperature information of the battery unit obtained directly to the processing circuit of the electronic device through I2C or other communication buses, without communicating with the power meter IC to obtain voltage, current, power and other parameters from the power meter IC, which simplifies the circuit design in the electronic device and reduces the cost, and also improves the communication efficiency.

The electronic device may be any terminal device including a mobile phone, a tablet computer, a personal digital assistant (PDA), a point of sales (POS), a vehicle-mounted computer, a wearable device, and the like.

The above embodiments only express a few implementation modes of the present disclosure, and the description is relatively specific and detailed, but it should not be understood as a limitation to the scope of the present disclosure. It should be noted that for those skilled in the art, without departing from the concept of the present disclosure, several modifications and improvements can be made, and these all fall within the scope of the present disclosure. Therefore, the scope of the present disclosure shall be subject to the appended claims.

## Claims

1. An electric quantity measuring apparatus, **characterized by** comprising:
a battery unit;
a sampling circuit, connected to the battery unit and configured to obtain a current signal of the battery unit; and
a charging management integrated circuit, arranged with a voltage detection pin and a current detection pin; wherein the voltage detection pin is connected to the battery unit, and the current detection pin is connected to the sampling circuit;
the charging management integrated circuit is configured to detect a voltage signal of the battery unit based on the voltage detection pin, detect the current signal of the battery unit based on the current sampling pin, and obtain voltage information, current information, and electric quantity information of the battery unit.

2. The apparatus according to claim 1, wherein the battery unit comprises one battery, and the voltage detection pin comprises a positive voltage detection pin and a negative voltage detection pin; a cathode tab of the battery is connected to the positive voltage detection pin, and an anode tab of the battery is connected to the negative voltage detection pin.

3. The apparatus according to claim 1, wherein the battery unit comprises a first battery and a second battery connected in series; the voltage detection pin comprises a positive voltage detection pin, a terminal voltage detection pin, and a negative voltage detection pin; the positive voltage detection pin is connected to a cathode tab of the first battery, the terminal voltage detection pin is connected to a cathode tab of the second battery, and the negative voltage detection pin is connected to an anode tab of the second battery.

4. The apparatus according to claim 1, wherein the battery unit comprises n batteries connected in series; the voltage detection pin comprises a positive voltage detection pin, n-1 terminal voltage detection pins, and a negative voltage detection pin; the positive voltage detection pin is connected to a cathode tab of a first battery, the negative voltage detection pin is connected to an anode tab of a nth battery, and a common terminal of each adjacent two of the n batteries is connected to a corresponding terminal voltage detection pin in a one-by-one manner; n is greater than 2.

5. The apparatus according to claim 4, further comprising a first equalization circuit; wherein the charging management integrated circuit is further arranged with first equalization pins, and the first equalization circuit is connected to the battery unit and the first equalization pins;
the charging management integrated circuit is further configured to control each first equalization pin to output a first equalization signal;
the first equalization circuit is configured to equalize the batteries according to the first equalization signal.

6. The apparatus according to claim 5, wherein the first equalization circuit comprises n first equalization units that are cascaded, and the number of the first equalization pins is n; a first terminal of the first equalization unit of each stage is connected to a cathode of a corresponding battery in a one-by-one manner, and a third terminal of the first equalization unit of each stage is connected to a corresponding equalization pin in a one-by-one manner; a second terminal of the first equalization unit of a n-1th stage is connected to a first terminal of the first equalization unit of a nth stage, and a second terminal of the first equalization unit of the nth stage is grounded.

7. The apparatus according to claim 6, wherein each first equalization unit comprises a first equalization resistor and a first equalization tube; a first terminal of the first equalization resistor is connected to the cathode of the corresponding battery as the first terminal of the each first equalization unit, a second terminal of the first equalization resistor is connected to a first terminal of the first equalization tube, a second terminal of the first equalization tube serves as the second terminal of the each first equalization unit, and a third terminal of the first equalization tube serves as the third terminal of the each first equalization unit.

8. The apparatus according to claim 7, wherein the first equalization tube 510 is a metal-oxide-semiconductor (MOS) tube; a drain of the MOS tube serves as the first terminal of the first equalization tube, a source of the MOS tube serves as the second terminal of the first equalization tube, and a gate of the MOS tube serves as the third terminal of the first equalization tube.

9. The apparatus according to claim 1, wherein the battery unit comprises n batteries connected in parallel; the voltage detection pin comprises n pairs of positive voltage detection pins and negative voltage detection pins; a cathode tab of each battery is connected to a corresponding positive voltage detection pin, and an anode tab of each battery is connected to a corresponding negative voltage detection pin; n is greater or equal to 2.

10. The apparatus according to claim 9, further comprising a second equalization circuit; wherein the charging management integrated circuit is further arranged with second equalization pins, and the second equalization circuit is connected to the battery unit and the second equalization pins;
the charging management integrated circuit is further configured to control each second equalization pin to output a second equalization signal;
the second equalization circuit is configured to equalize the batteries according to the second equalization signal.

11. The apparatus according to claim 10, wherein the second equalization circuit comprises n second equalization units, and the number of the second equalization pins is n; a first terminal of each second equalization unit is connected in series with a cathode of a corresponding battery in a one-by-one manner, a second terminal of each second equalization unit is connected to the sampling circuit, and a third terminal of each second equalization unit is connected to a corresponding second equalization pin in a one-by-one manner.

12. The apparatus according to claim 11, wherein the second equalization unit comprises a second equalization tube.

13. The apparatus according to claim 1, wherein the charging management integrated circuit is further arranged with a control pin configured to output a charging instruction;
the apparatus further comprises:
an interface module, connected to the battery unit and the charging management integrated circuit and configured to connect to a charging device;
a charging circuit, connected to the interface module, the sampling circuit, and the control pin, and configured to receive the charging instruction and to turn on a charging path between the interface module and the battery unit according to the charging instruction, for charging the battery unit.

14. The apparatus according to claim 13, wherein the charging circuit comprises a first metal-oxide-semiconductor, MOS, tube and a second MOS tube; a gate of the first MOS tube and a gate of the second MOS tube are both connected to the control pin; a drain of the first MOS tube is connected to the interface module; a source of the first MOS tube is connected to a source of the second MOS tube; a drain of the second MOS tube is connected to the sampling circuit.

15. The apparatus according to claim 14, wherein in condition of the charging device connected to the interface module being a fast-charging adapter, the charging management integrated circuit outputs a high-level control signal to the gate of the first MOS tube and the gate of the second MOS tube, such that the first MOS transistor and the second MOS transistor are both in an on state, for charging the battery unit.

16. The apparatus according to claim 13, wherein the sampling circuit is a sampling resistor; a first terminal of the sampling resistor is connected to a cathode terminal of the battery unit, and a second terminal of the sampling resistor is connected to the interface module.

17. The apparatus according to claim 1, further comprising a temperature detection circuit configured to detect temperature information of the battery unit; wherein the charging management integrated circuit is further arranged with a temperature detection pin; a first terminal of the temperature detection circuit is connected to an anode terminal of the battery unit, and a second terminal of the temperature detection circuit is connected to the temperature detection pin;
the charging management integrated circuit is further configured to obtain the temperature information of the battery unit.

18. The apparatus according to claim 1, further comprising a protection circuit connected to the battery unit and the charging management integrated circuit;
the protection circuit is configured to protect the battery unit from over-voltage or over-current.

19. An electric quantity measuring method, comprising:
receiving a configuration instruction;
configuring a voltage detection pin and a current detection pin according to the configuration instruction; wherein a positive voltage detection pin is connected to a first terminal of a sampling circuit and a cathode terminal of a battery unit; a negative voltage detection pin is connected to a second terminal of the sampling circuit; the sampling circuit is configured to obtain a current signal of the battery unit; and
obtaining voltage information, current information, and electric quantity information of the battery unit based on a voltage signal detected by the voltage detection pin and the current signal detected by the current sampling pin.

20. The method according to claim 19, wherein the battery unit comprises a plurality of batteries, and the method further comprises:
obtaining a voltage signal of each battery of the battery unit;
in response to the voltage signal of each battery meeting an equalization condition, controlling an equalization circuit to perform an equalization process on the battery unit; wherein the equalization circuit is connected to each battery.

21. An electronic device, **characterized by** comprising:
a battery unit;
a sampling circuit, connected to the battery unit and configured to obtain a current signal of the battery unit;
a charging management integrated circuit, arranged with a voltage detection pin and a current detection pin; wherein the voltage detection pin is connected to the battery unit, and the current detection pin is connected to the sampling circuit;
the charging management integrated circuit is configured to detect a voltage signal of the battery unit based on the voltage detection pin, detect the current signal of the battery unit based on the current sampling pin, and obtain voltage information, current information, and electric quantity information of the battery unit; and
a processing circuit, connected to the battery unit and the charging management integrated circuit, and configured to receive the current signal, the voltage signal, and the electric quantity information output by the charging management integrated circuit and to manage the charging management integrated circuit.

22. The electronic device according to claim 21, wherein the battery unit comprises one battery, and the voltage detection pin comprises a positive voltage detection pin and a negative voltage detection pin; a cathode tab of the battery is connected to the positive voltage detection pin, and an anode tab of the battery is connected to the negative voltage detection pin.

23. The electronic device according to claim 21, wherein the battery unit comprises a first battery and a second battery connected in series; the voltage detection pin comprises a positive voltage detection pin, a terminal voltage detection pin, and a negative voltage detection pin; the positive voltage detection pin is connected to a cathode tab of the first battery, the terminal voltage detection pin is connected to a cathode tab of the second battery, and the negative voltage detection pin is connected to an anode tab of the second battery.

24. The electronic device according to claim 21, wherein the battery unit comprises n batteries connected in series; the voltage detection pin comprises a positive voltage detection pin, n-1 terminal voltage detection pins, and a negative voltage detection pin; the positive voltage detection pin is connected to a cathode tab of a first battery, the negative voltage detection pin is connected to an anode tab of a nth battery, and a common terminal of each adjacent two of the n batteries is connected to a corresponding terminal voltage detection pin in a one-by-one manner; n is greater than 2.

25. The electronic device according to claim 21, wherein the battery unit comprises n batteries connected in parallel; the voltage detection pin comprises n pairs of positive voltage detection pins and negative voltage detection pins; a cathode tab of each battery is connected to a corresponding positive voltage detection pin, and an anode tab of each battery is connected to a corresponding negative voltage detection pin; n is greater or equal to 2.
